# EUROPÄISCHE PATENTSCHRIFT

(11) **EP 1 729 311 B1**
(45) Veröffentlichungstag und Bekanntmachung des Hinweises auf die Patenterteilung: **02.04.2008**
(21) Anmeldenummer: 06114092.7
(22) Anmeldetag: 17.05.2006
(51) Int. Cl.: H01G 2/02, H05K 7/12

(54) **Halter für einen Kondensator**
Holder for a capacitor
Support pour un condensateur

(30) Priorität: 02.06.2005 DE 102005025832
(43) Veröffentlichungstag der Anmeldung: 06.12.2006
(73) Patentinhaber: AIC-EUROPE elektronische Bauteile GmbH, 47829 Krefeld (DE)
(72) Erfinder: Frank, Bernhard, 47802 Krefeld (DE)
(74) Vertreter: Buchhold, Jürgen

(56) Entgegenhaltungen:
- EP-A- 1 515 596
- DE-A1- 4 038 689
- PATENT ABSTRACTS OF JAPAN Bd. 1996, Nr. 07, 31. Juli 1996 (1996-07-31) & JP 08 064457 A (FUJITSU GENERAL LTD), 8. März 1996 (1996-03-08)

## Beschreibung

Die vorliegende Erfindung betrifft eine Haltereinrichtung geeignet für einen Kondensator, insbesondere für einen Aluminium-Elektrolyt-Kondensator, zur Befestigung des Kondensators an einem Anschlusselement, umfassend: einen Körper und eine den Körper axial durchdringende, durchgehende Durchgangsöffnung zur Aufnahme des Kondensators, wobei die Durchgangsöffnung im Wesentlichen die gleichen Innenabmessungen wie die Außenabmessung des aufzunehmenden, im zusammengebauten Zustand den Körper bzw. die Durchgangsöffnung zumindest teilweise durchdringenden Kondensators aufweist, um den Kondensator aufzunehmen.

Weiter betrifft die vorliegende Erfindung eine Halter-Kondensator-Anordnung umfassend: einen Kondensator ausgewählt aus der Gruppe der Elektrolyt-Kondensatoren, umfassend Aluminium-Elektrolyt-Kondensatoren, mit einem einen Becherboden aufweisenden Becher und einer umfänglichen Außenisolierung, und einen korrespondierenden Halter.

Zudem umfasst die vorliegende Erfindung eine Kondensator-Anschlusselement-Anordnung, umfassend: eine Halter-Kondensator-Anordnung, ein mit dem Halter verbindbares Anschlusselement und eine sandwichartig zwischen Becherboden und Anschlusselement angeordnete Folie.

Derartige Halter bzw. Anordnungen kommen in vielen Systemen zum Einsatz, bei denen entsprechende Elektrolyt-Kondensatoren an Anschlusselementen sowohl vertikal als auch horizontal angebracht werden.

Bekannt sind verschiedene Kondensatoren und Halter-Kondensator-Kombinalionen. Aus der DE 39 19 483 A1 ist ein Elektrolyt-Kondensator bekannt. Bei dem bekannten Elektrolyt-Kondensator weist sowohl der Becher als auch der Deckel aus Aluminium eine gasdichte Verschweißung von Deckel und Becher über eine Laserschweißnaht auf, die sich über den Außenumfang der von dem Becherdeckel gebildeten Einheit erstreckt.

Aus der DE 38 43 652 A1 ist ein ähnlicher Elektrolyt-Kondensator bekannt.

Aus der DE 100 56 474 A1 ist ein Gehäuse, eine Gehäuseanordnung und ein Elektrolyt-Kondensator mit dem Gehäuse und der Anordnung des Elektrolyt-Kondensators bekannt. Der Gegenstand betrifft ein Gehäuse mit einem elektrisch leitfähigen Becher, der eine Wand und einen Boden umfasst, mit einer elektrisch isolierenden Umhüllung, die die Außenseite des Bechers bedeckt und die bodenseitig eine Öffnung aufweist, die kleiner als der Boden des Bechers ist, mit einem Füllelement, das gut wärmeleitend ist und das innerhalb der Öffnung angeordnet ist, und mit einem Abdeckelement, das elektrisch isolierend ist, das den Boden des Bechers bedeckt und das die Umhüllung überlappt. Ferner betrifft die Erfindung einen Elektrolyt-Kondensator mit einem Rundwickel und dem Gehäuse sowie eine Gehäuseanordnung oder eine Anordnung eines Elektrolyt-Kondensators. Durch die Verwendung eines ebenen Becherbodens in Verbindung mit einem Füllelement und mit einem Abdeckelement kann eine verbesserte Wärmeableitung des Gehäuses bei vermindertem Herstellungsaufwand für den Becher erreicht werden.

Aus der DE 196 42 462 A1 ist eine Form von Becher-Elektrolyt-Kondensatoren bekannt. Nach dem dort offenbarten Gegenstand werden neue Formen für Becher-Elektrolyt-Kondensatoren offenbart, die eine wirksame Ableitung von im Betrieb entstandener Wärme herbeiführen. Dies erfolgt dadurch, dass der Boden des Bechers, der mit einer Wärmeleitfolie bedeckt ist, auf das Chassis oder die Kondensatorauflage gepresst wird. Dies wird dadurch gewährleistet, dass der Schrumpfschlauch in der Einziehung kurz oberhalb des Becherbodens endet. Der innige Kontakt zum Kühlkörper wird durch Pressdruck erreicht, der durch Verschraubung von Überwurfringen mit Kondensatorauflage herbeigeführt wird. Der Überwurfring wird durch die Außendicke der Becherwand gehalten.

Aus der DE 40 38 689 A1 ist eine Vorrichtung zur klemmenden Halterung eines zylindrischen, stehend auf einem Träger angeordneten Bauelements, insbesondere eines Kondensators, bestehend aus einem Halter zur Befestigung an dem Träger bekannt, wobei der Halter aus einem Rohr mit dem Bauelement angepasstem Innendurchmesser und mit einem Bund an dem einen Ende sowie nach innen gerichteten, federnden Vorsprüngen am anderen Ende besteht, der von der einen Seite des Trägers durch eine entsprechende Öffnung bis zum Anschlag des Bundes gesteckt und mittels vorstehender Rastnasen auf der anderen Seite des Trägers verrastet ist.

Nachteilig an all den vorgenannten Gegenständen ist, dass diese nur eine unzureichende Befestigung an möglichen Anschlusselementen aufweisen, da, wie im Falle der DE 196 42 462 A1, nur ein Überwurfring vorgesehen ist, der hinsichtlich Stabilität und Halterung nicht den Ansprüchen z.B. bei Befestigung an einer vertikalen Wand, von der der Kondensator dann horizontal absteht, genügt.

Zudem sind einige der vorstehend aufgeführten, von dem Standard abweichende Kondensatoren aufwendig herzustellen, wie z.B. im Falle der DE 196 42 462 A1, welche zusätzliche Einziehungen am Becherboden aufweist.

Weiterhin weisen ggf. vorhandene Haltereinrichtungen keine Selbstzentrierung auf, so im Falle der DE 196 42 462 A1, so dass diese in schwieriger zugänglichen Lagen nur schwer ausgerichtet und zentriert angeordnet werden können.

Aufgabe der vorliegenden Erfindung ist es somit, die vorstehend aufgeführten Nachteile zu überwinden.

Insbesondere ist es Aufgabe der vorliegenden Erfindung, eine Haltereinrichtung zu schaffen, welche einen Kondensator sicher und zuverlässig aufnimmt, eine stabile und zuverlässige Anordnung bzw. Halterung des Kondensators an einem möglichen Anschlusselement gewährleistet und welche zudem eine Selbstzentrierung des Kondensators ermöglicht.

Eine weitere Aufgabe ist zudem, eine Halter-Kondensator-Anordnung zu schaffen, bei welcher der Kondensator sicher und zuverlässig an einem Anschlusselement befestigt werden kann, wobei ein ausreichender Anpressdruck zwischen Halter/Kondensator und Anschlusselement gewährleistet ist

Weiterhin ist es eine Aufgabe der vorliegenden Erfindung, eine Kondensator-Anschlusselement-Anordnung zu schaffen, bei der ein Kondensator mittels Halter zuverlässig und sicher auf einem Anschlusselement beispielsweise einem Kühlelement angeordnet ist, wobei ein ausreichender Anpressdruck und eine zuverlässige Wärmeableitung gewährleistet ist.

Diese Aufgabe wird ausgehend von einer Haltereinrichtung gemäß dem Oberbegriff des Anspruchs 1, einer Halter-Kondensator-Anordnung gemäß dem Oberbegriff des Anspruchs 7 und einer Kondensator-Anschlusselement-Anordnung gemäß dem Oberbegriff des Anspruchs 12 in Verbindung mit den hierauf folgenden Merkmalen gelöst. Vorteilhafte Weiterbildungen der Erfindung sind in den abhängigen Ansprüchen angegeben.
Die Erfindung schließt die technische Lehre ein, dass bei einer Haltereinrichtung, insbesondere für einen Aluminium-Elektrolyt-Kondensator, umfasst sind: ein Körper und eine den Körper axial durchdringende, durchgehende Durchgangsöffnung zur Aufnahme eines Kondensators, wobei die Durchgangsöffnung im Wesentlichen die gleichen Innenabmessungen wie die Außenabmessungen des aufzunehmenden, im zusammengebauten Zustand den Körper bzw. die Durchgangsöffnung zumindest teilweise durchdringenden Kondensators aufweist, um den Kondensator aufzunehmen, wobei der Körper mehrere Teilbereiche umfasst, einen unteren Teilbereich mit Verbindungsmitteln zum anpressbaren Verbinden des Körpers an ein Anschlusselement und einer unteren Durchgangsöffnungabmessung, welche eine spielbehaftete Aufnahme des Kondensators ermöglicht, einen mittleren Teilbereich mit einer gegenüber der unteren Durchgangsöffnungabmessung, kleineren mittleren Durchgangsöffnungabmessung, welcher so einen ersten inneren Absatz gegenüber dem unteren Teilbereich bildet und einen oberen Teilbereich mit einer gegenüber der mittleren Durchgangsöffnungabmessung kleineren oberen Durchgangsöffnungabmessung, welcher so einen zweiten inneren Absatz gegenüber dem mittleren Teilbereich bildet.

Vorteilhaft an dieser Ausführung ist, dass der Halter mehrere Teilbereiche aufweist, welche geeignet sind, eine Selbstzentrierung, z.B. bei der Montage des aufzunehmenden Kondensators, zu ermöglichen. Durch die verschiedenen Absätze, welche zum Teil als Anschlag dienen, lässt sich der Kondensator zuverlässig, sicher und stabil anordnen.

Bevorzugt ist, dass der Körper bzw. die Teilbereiche im Wesentlichen ringförmig ausgebildet sind. Da auch die Kondensatoren im Wesentlichen zylindrisch ausgebildet sind, ist hierdurch eine sichere Aufnahme des Kondensators möglich. Durch die ringförmige Ausgestaltung ist eine einfache Herstellung gewährleistet.

Weiter bevorzugt ist, dass die Querschnitte der Durchgangsöffnung als kreisförmige Querschnitte ausgebildet sind. Die kreisförmigen Querschnitte lassen sich einfach herstellen und ermöglichen eine einfache Verwendung mit im Querschnitt zylindrischen Kondensatoren.

Zudem ist bevorzugt, dass der obere Teilbereich eine verdünnte Wandstärke aufweist, um eine federnde Wirkung zu realisieren. Mittels dieser federnden Wirkung lässt sich bei entsprechenden Toleranzen eine Selbstjustage des Kondensators bei Aufnahme im Halter durchführen.

Außerdem bevorzugt ist, dass der obere Teilbereich im Umfang ausgebildete Ausnehmungen aufweist, um laschenartige federnde Führungsmittel auszubilden. Durch die laschenartige Ausbildung erreicht man eine bessere Federung, wobei die Toleranzen enger bemessen werden können, und trotzdem eine Selbstjustage realisiert bleibt. Zudem erhält man eine Gewichtsersparnis.

Außerdem bevorzugt ist, dass der Halter aus einem ausreichend stabilen Werkstoff, ausgewählt aus der Gruppe der Kunststoffe, umfassend PBT (Polybuthylenterephthalat), hergestellt ist. Dieser Werkstoff bietet eine ausreichende Stabilität bei einem geringen Eigengewicht, ist wetterbeständig und lässt sich für die verschiedenen Zwecke als Halter hervorragend einsetzen.

Die technische Lehre umfasst weiter, dass die Halter-Kondensator-Anordnung umfasst: einen Kondensator mit einem einen Becherboden aufweisenden Becher und einer umfänglichen Außenisolierung, ausgewählt aus der Gruppe der Elektrolytkondensatoren umfassend Aluminium-Elektrolyt-Kondensatoren und einen korrespondierenden Halter, ausgewählt aus der Gruppe der Haltevorrichtungen umfassend einen Überwurfring und eine Haltereinrichtung gemäß einem der Ansprüche 1-6. Mit dieser erfindungsgemäßen Haltereinrichtung lässt sich eine sichere, zuverlässige Halterung des Kondensators an verschiedenen Anschlusselementen gewährleisten. Insbesondere bei vertikalen Wänden, von denen der Kondensator dann horizontal hervorsteht, ist eine optimale Halterung, welche zusätzlich bei der Montage selbstjustierend ist, ausgeführt.

Bevorzugt ist, dass der Becherboden absatzfrei ausgebildet ist. Auf diese Weise lassen sich einfach herzustellende Kondensatoren, insbesondere Standardkondensatoren einsetzen. Es müssen keine Spezielanfertigungen an Kondensatoren, welche speziell angefertigte Bereiche zur Aufnahme in Halterungen benötigen, ausgeführt werden.

Auch bevorzugt ist, dass die Außenisolierung im Wesentlichen bündig mit dem Becherboden abschließt. Somit müssen keine Einziehungen am Kondensator ausgebildet werden, um die Außenisolierung in dieser Einziehung zumindest teilweise anzuordnen. Somit lässt sich die Außenisolierung leichter herstellen.

Weiter bevorzugt ist, dass der Kondensator einen zumindest teilweise umfänglichen radialen Vorsprung aufweist, welcher mit dem ersten inneren Absatz zusammenwirkt, um beim Zusammenfügen von Halter und Kondensator ein Anschlag zu realisieren. Mittels dieses Anschlags lässt sich der Anpressdruck der bei Anbringen an einen Anschlusselement notwendig ist, einstellen.

Zudem bevorzugt ist, dass der Kondensator eine zumindest teilweise umfängliche radiale Ausnehmung aufweist, welche mit dem zweiten inneren Absatz zusammenwirkt, um beim Zusammenfügen von Halter und Kondensator eine Zentrierung zu realisieren. Durch diese Ausnehmung an dem Kondensator ist eine einfache Selbstjustierung realisierbar.

Weiter umfasst die technische Lehre, dass bei einer Kondensator-Anschlusselement-Anordnung umfasst ist: eine Halter-Kondensator-Anordnung gemäß dem vorstehenden, ein mit dem Halter verbindbares Anschlusselement und eine sandwichartig zwischen Becherboden und Anschlusselement angeordnete Folie, wobei die Folie ausgebildet ist, einen ausreichenden Kriechabstand zu gewährleisten. Dabei ist sichergestellt, dass es in keinerlei Richtung zu einem ungewollten Kriechen eines elektrischen Stroms kommt, beispielsweise zwischen Kondensator und Haltereinrichtung oder Kondensator und Anschlusselement.

Vorteilhaft daran ist, dass diese Folie zum Einen einen ausreichenden Kriechabstand gewährleistet, um ein sicheres Funktionieren des Kondensators zu ermöglichen und dass zum Anderen die Folie eine ausreichende Wärmeabfuhr realisiert. Eine ausreichende Wärmeabfuhr sorgt dafür, dass die Temperatur, die der Kondensator maximal erfahren kann, nicht überschritten wird.

Deshalb ist weiter bevorzugt, dass die Folie ausgebildet ist, eine geeignete Wärmeableitung zu realisieren. Somit findet keine Funktionsbeeinträchtigung beispielsweise durch Überhitzung des Kondensators statt.

Auch bevorzugt ist, dass die Folie die gesamte Kontaklfläche zwischen Becherboden und Anschlusselement und/oder Haltereinrichtung und Anschlusselement bedeckt. Insbesondere durch die fehlende Einziehung oder Abstufung der Kondensatorunterfläche bzw. des Becherbodens lässt sich eine große Kontaktfläche realisieren. Vorteilhaft ist, dass die gesamte Kontaktfläche als Wärmeableitung genutzt wird.

Zudem ist bevorzugt, dass die Folie eine Dicke aufweist, um einen ausreichenden Kriechabstand zu gewährleisten.

Mit diesen Bereichen ist die Folie ausreichend klein dimensioniert, um einerseits einen ausreichenden Kriechabstand nach DIN bzw. anderen Industrienormen zu gewährleisten, wobei jedoch auch eine ausreichende Wärmeableitung gewährleistet ist. Zudem ist die Folie recht kleinbauend.

Weiter bevorzugt ist, dass das Anschlusselement ausgewählt ist aus der Gruppe der Kühlelemente, umfassend Kühlkörper und Kühlplatten. Mittels dieser aktiven Kühlung lässt sich der Kondensator in einem optimalen Betriebstemperaturbereich halten, so dass eine optimale Funktionsweise gewährleistet ist.

Auch bevorzugt ist, dass die Haltereinrichtung im unteren Teilbereich mit dem Anschlusselement zusammenwirkende Verbindungsmittel aufweist, um beim Verbinden von Anschlusselement, Folie und Halter-Kondensator-Anordnung einen ausreichenden Anpressdruck zu realisieren. Hierdurch lässt sich eine optimale Befestigung des Kondensators auch an vertikalen Wänden realisieren. Auch bevorzugt ist, dass der Becherboden vor Verbinden von Anschlusselement, Folie und Halter-Kondensator-Anordnung mit etwas Spiel über den Bodenbereich der Haltereinrichtung hervorsteht, um einen ausreichend hohen Anpressdruck zwischen Kondensator und Anschlusselement zu realisieren.

Weitere die Erfindung verbessernde Maßnahmen sind in den Unteransprüchen angegeben oder werden nachstehend gemeinsam mit der Beschreibung mehrerer bevorzugter Ausführungsbeispiele der Erfindung anhand der Figuren näher dargestellt Es zeigen:
- Fig. 1: eine Seitenansicht eines quergeschnittenen Halters
- Fig.2: eine Draufsicht auf den Halter nach Fig.1
- Fig.3: eine andere Ausführungsform eines Halters in einer Seitenansicht, welche einen Schnitt durch diesen Halter zeigt
- Fiig.4: eine Draufsicht auf den Halter nach Fig.3
- Fig.5: eine zu dem Halter nach Fig.1 und/oder 2 zugehörige Folie und
- Fig.6: eine geeignete Folie für den Halter nach Fig.3 und/oder 4.

Fig. zeigt ein erfindungsgemäßen Haltereinrichtung 10 in einem Querschnitt. Die Haltereinrichtung 10 ist im Wesentlichen ringförmig ausgebildet, mit einem Körper 20 und einen den Körper 20 entlang einer Längsachse A durchdringenden Durchgangsöffnung 30. Die Durchgangsöffnung 30 ist im Wesentlichen zylindrisch ausgebildet, mit unterschiedlichen Durchmessern. Insbesondere weist die Durchgangsöffnung 30 drei unterschiedliche Durchmesser auf. Aufgrund dieser drei unterschiedlichen Durchmesser ist der Körper 20 in drei Teilbereich eingeteilt. Daher weist der Körper einen unteren Teilbereich 21 auf. Die Durchgangsbohrung in diesem Abschnitt weist den größten Durchmesser der Durchgangsbohrungsabschnitte auf. Dieser ist etwas größer als der (Außen-)Durchmesser des aufzunehmenden Kondensators, so dass eine spielbehaftete Aufnahme des Kondensators in der Haltereinrichtung möglich ist. Der untere Teilbereich 21 weist im Wesentlichen drei Wandstärken auf, wobei die Wandstärke im Bereich, an dem der die Haltereinrichtung 10 mit einem Anschlusselement verbunden werden soll, den größten Wandbereich aufweist. In diesem Bereich sind Durchgangsbohrungen angeordnet, um eine Verbindung mit dem Anschlusselement mittels beispielsweise Schrauben oder anderen Verbindungselementen zu gewährleisten. In Richtung zum zweiten Teilbereich 22 verjüngt sich die Wandstärke; ist mittels einer Schräge jedoch stabilisiert. Beim Übergang vom unteren Teilbereich 21 zum mittleren Teilbereich 22 weist der Körper 20 einen zum Außendurchmesser des ersten Teilbereichs 21 gleich großen Außendurchmesser auf. Jedoch ist die Durchgangsöffnungsbohrung im mittleren Teilbereich 22 bzw. der Durchmesser kleiner als im unteren Teilbereich 21, so dass beim Übergang innen ein Absatz entsteht. Der Durchmesser der Durchgangsöffnung im mittleren Teilbereich 22 entspricht in etwa dem Durchmesser des Kondensators und ermöglicht eine sichere Halterung. An dem mittleren Teilbereich 22 schließt der obere Teilbereich 23 an, welcher umfänglich angeordnete Ausnehmungen 40 aufweist, so dass Laschen entstehen. Die Wandstärke ist hier geringer als im mittleren Teilbereich 22, genau wie der Durchmesser der Durchgangsöffnung im Vergleich zu den beiden vorherigen Teilbereichen 21, 22. Der Durchmesser der Durchgangsöffnung in diesem oberen Teilbereich 23 ist so ausgelegt, dass kein Spiel zwischen Kondensator und Innenwandung des oberen Teilbereichs entsteht. Dadurch, dass die Wandstärke dünner ausgebildet ist und dass zusätzlich Laschen ausgebildet sind, entsteht ein federnder oberer Bereich oder Abschnitt, der den Kondensator aufnimmt und selbstzentriert.

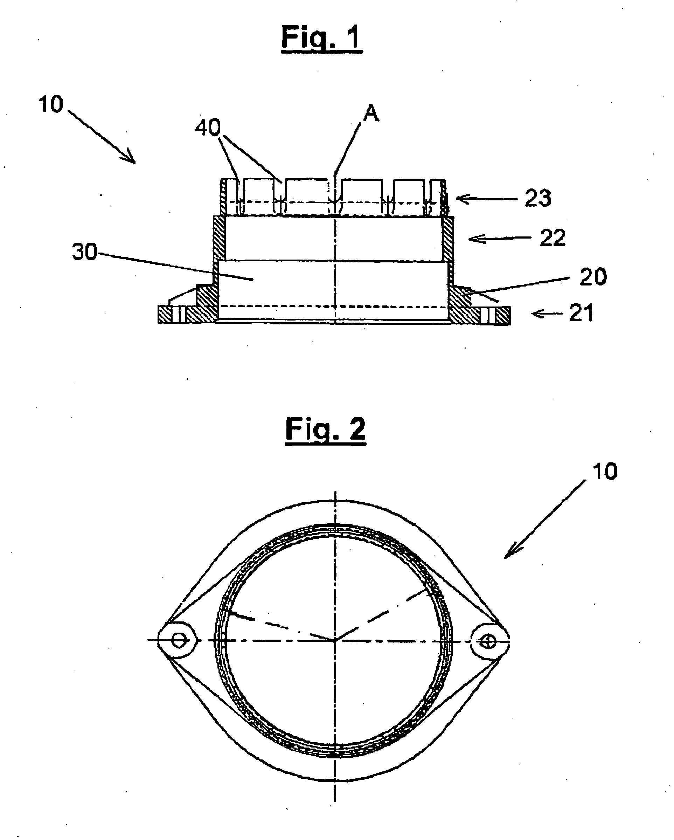

Fig.2 zeigt den in Fig.1 dargestellten Halter in einer Draufsicht .

In Fig.2 wird deutlich, dass die Haltereinrichtung 10 einen in der Grundfläche, das heißt der Kontaktfläche zwischen Haltereinrichtung 10 und dem Anschlusselement, etwa mandelförmigen Querschnitt aufweist, wobei dieser sich axial nach oben in Richtung oberer Teilbereich zu einem zylindrischen oder ringförmigen Querschnitt ändert. Der Halter oder die Haltereinrichtung 10 wird insgesamt von unten, d.h. vom unteren Teilbereich bis zum oberen Teilbereich dünner. An den beiden Enden links und rechts weist die Haltereinrichtung 10 eine Verstärkung auf, in welcher Durchgangsöffnungen zur Verbindung der Haltereinrichtung 10 mit einem Anschlusselement angeordnet sind.

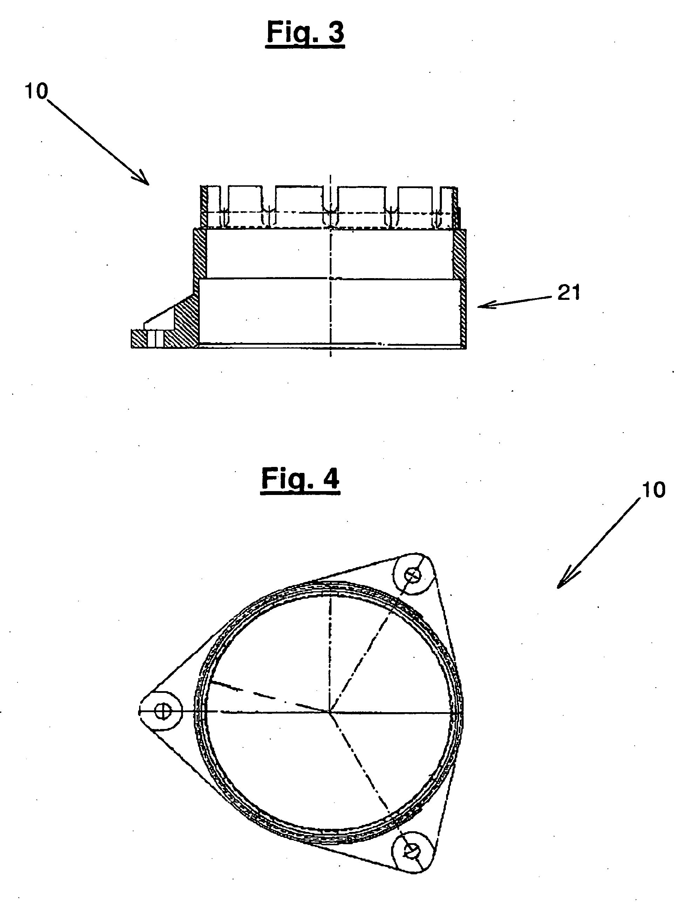

Fig.3 zeigt eine andere Ausführungsform eines Halters oder einer Haltereinrichtung 10 nach Fig.1. Im Wesentlichen weist die Haltereinrichtung nach Fig.3 die gleiche Struktur wie der Halter nach Fig.1 auf. Unterschied ist hierbei, dass die Grundfläche, d.h. der untere Abschnitt oder Bereich des unteren Teilbereichs 21 anders ausgebildet ist, nämlich, dass eine andere Anzahl von Durchgangsbohrungen für eine Verbindung mit einem Anschlusselement und ein anderer Querschnitt somit vorhanden sind. Die Grundfläche ist hier nach Art eines abgerundeten Dreiecks ausgebildet und weist in den drei Eckbereichen je eine Durchgangsöffnung auf.

In Fig.4 ist in der Draufsicht deutlich zu sehen, dass die Grundfläche, d.h. der untere Abschnitt des unteren Teilbereichs nicht mehr mandelförmig, sondern nach Art eines Dreiecks etwa ausgebildet ist. An diesen drei Ecken weist der untere Abschnitt drei Durchgangsbohrungen auf, mit denen die Haltereinrichtung 10 an einem Anschlusselement angeordnet werden kann.

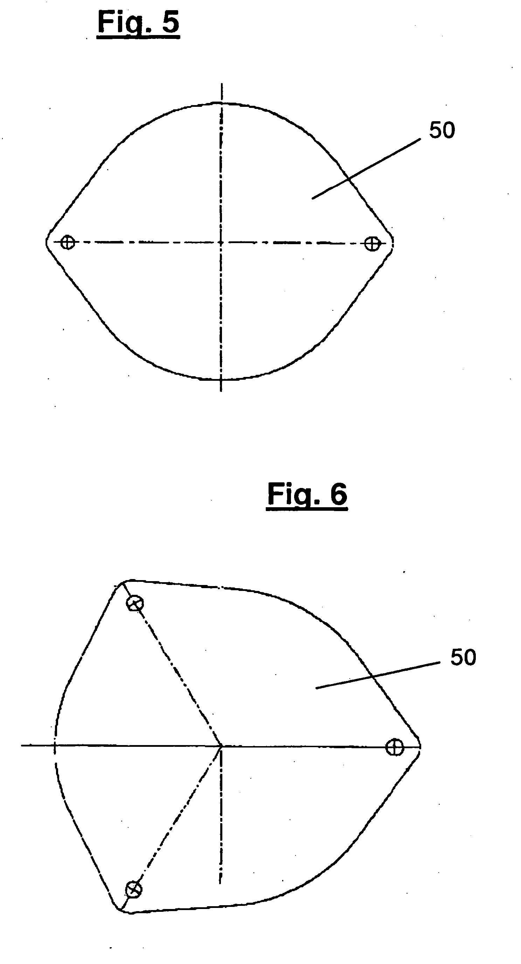

Fig.5 zeigt in der Draufsicht die zu Fig. und/oder Fig.2 zugehörende Folie 50. Die Folie 50 weist denselben Querschnitt auf wie der untere Abschnitt bzw. die Grundfläche des Halters bzw. der Haltereinrichtung und weist an den spitzzulaufenden Enden jeweils Durchgangsbohrungen auf, damit die Folie zwischen Anschlusselement und Haltereinrichtung mit der Haltereinrichtung und dem Anschlusselement verbunden werden kann.

Fig.6 zeigt dahingehend eine zu Fig.3 und 4. entsprechende Folie 50. Diese weist entsprechend Fig.5 ebenfalls die gleiche Grundfläche bzw. den gleichen Querschnitt wie der untere Abschnitt des unteren Teilbereichs von Fig.3 und 4 auf mit jeweils einer an den Ecken angeordneten Durchgangsbohrung zur Befestigung der Folie 50 zwischen Anschlusselement und Haltereinrichtung.

### Bezugszeichenliste

- **10**: Haltereinrichtung
- **20**: Körper
- **21**: unterer Teilbereich
- **22**: mittlerer Teilbereich
- **23**: oberer Teilbereich
- **30**: Durchgangsöffnung
- **40**: Ausnehmungen
- **50**: Folie

## Patentansprüche

1. Haltereinrichtung (10) geeignet für einen Kondensator, insbesondere für einen Aluminium-Elektrolyt-Kondensator, zur Befestigung des Kondensators an einem Anschlusselement, umfassend:
einen Körper (20) und
eine den Körper (20) axial durchdringende, durchgehende Durchgangsöffnung (30) zur Aufnahme des Kondensators,
wobei die Durchgangsöffnung (30) im Wesentlichen die gleichen Innenabmessungen wie die Außenabmessung des aufzunehmenden, im zusammengebauten Zustand den Körper (20) bzw. die Durchgangsöffnung (30) zumindest teilweise durchdringenden Kondensators aufweist, um den Kondensator aufzunehmen,
**dadurch gekennzeichnet, dass**
der Körper (20) mehrere Teilbereiche umfasst,
einen unteren Teilbereich (21) mit Verbindungsmitteln zum anpressbaren Verbinden des Körpers (20) an ein Anschlusselement und mit einer unteren Durchgangsöffnungabmessung, welche eine spielbehaftete Aufnahme des Kondensators ermöglicht,
einem mittleren Teilbereich (22) mit einer gegenüber der unteren Durchgangsöffnungabmessung kleineren, mittleren Durchgangsöffnungabmessung, welcher so einen ersten inneren Absatz gegenüber dem unteren Teilbereich (21) bildet und
einem oberen Teilbereich (23) mit einer gegenüber der mittleren Durchgangsöffnungabmessung kleineren oberen Durchgangsöffnungabmessung, welcher so einen zweiten inneren Absatz gegenüber dem mittleren Teilbereich (22) bildet.

2. Haltereinrichtung (10) nach Anspruch 1,
**dadurch gekennzeichnet, dass**
der Körper (20) beziehungsweise die Teilbereiche (21, 22, 23) im Wesentlichen ringförmig ausgebildet sind.

3. Haltereinrichtung (10) nach Anspruch 1 oder 2,
**dadurch gekennzeichnet, dass**
die Querschnitte der Durchgangsöffnung (30) als kreisförmige Querschnitte ausgebildet sind.

4. Haltereinrichtung (10) nach einem der vorherigen Ansprüche 1 bis 3,
**dadurch gekennzeichnet, dass** der obere Teilbereich (23) eine verdünnte Wandstärke aufweist, um eine federnde Wirkung zu realisieren.

5. Haltereinrichtung (10) nach einem der vorherigen Ansprüche 1 bis 4,
**dadurch gekennzeichnet, dass**
der obere Teilbereich (23) am Umfang ausgebildete Ausnehmungen (40) aufweist, um laschenartige, federnde Führungsmittel auszubilden.

6. Haltereinrichtung (10) nach einem der vorherigen Ansprüche 1 bis 5,
**dadurch gekennzeichnet, dass** der Körper (20) aus einem ausreichend stabilen Werkstoff ausgewählt aus der Gruppe der Kunststoffe umfassend PBT (Polybutylenterephthalat) hergestellt ist.

7. Halter-Kondensator-Anordnung umfassend:
einen Kondensator mit
einem einen Becherboden aufweisenden Becher und
einer umfänglichen Außenisolierung,
ausgewählt aus der Gruppe der Elektrolyt-Kondensatoren umfassend Aluminium-Elektrolyt-Kondensatoren und
einen korrespondierenden Halter,
**dadurch gekennzeichnet, dass**
der Halter eine Haltervorrichtung, umfassend einen Überwurfring und eine Haltereinrichtung (10) gemäß einem der vorherigen Ansprüche, umfasst.

8. Halter-Kondensator-Anordnung nach Anspruch 7,
**dadurch gekennzeichnet, dass**
der Becherboden absatzfrei ausgebildet ist.

9. Halter-Kondensator-Anordnung nach einem der Ansprüche 7 oder 8,
**dadurch gekennzeichnet, dass**
die Außenisolierung im Wesentlichen bündig mit dem Becherboden abschließt

10. Halter-Kondensator-Anordnung nach einem der vorherigen Ansprüche 7 bis 9,
**dadurch gekennzeichnet; dass**
der Kondensator einen zumindest teilweise umfänglichen radialen Vorsprung aufweist, welcher mit dem ersten inneren Absatz zusammenwirkt, um beim Zusammenfügen von Halter und Kondensator einen Anschlag zu realisieren.

11. Halter-Kondensator-Anordnung nach einem der vorherigen Ansprüche 7 bis 10,
**dadurch gekennzeichnet, dass**
der Kondensator eine zumindest teilweise umfängliche radiale Ausnehmung aufweist, welche mit dem zweiten inneren Absatz zusammenwirkt, um beim Zusammenfügen von Halter und Kondensator eine Zentrierung zu realisieren.

12. Kondensator-Anschlusselement-Anordnung, **gekennzeichnet durch**:
eine Halter-Kondensator-Anordnung nach einem der vorherigen Ansprüche 7 bis 11, ein mit dem Halter verbindbares Anschlusselement und
eine sandwichartig zwischen Becherboden und Anschlusselement angeordnete Folie (50), wobei die Folie (50) ausgebildet ist, einen ausreichenden Kriechabstand zu gewährleisten.

13. Kondensator-Anschlusselement-Anordnung nach Anspruch 12, umfassend,
**dadurch gekennzeichnet, dass**
die Folie (50) ausgebildet ist, eine geeignete Wärmeableitung zu realisieren

14. Kondensator-Anschlusselement-Anordnung nach Anspruch 12 oder 13,
**dadurch gekennzeichnet, dass**
die Folie (50) die gesamte Kontaktfläche zwischen Becherboden und Anschlusselement und/oder Haltereinrichtung (10) und Anschlusselement bedeckt.

15. Kondensator-Anschlusselement-Anordnung nach einem der vorherigen Ansprüche 12 bis 14,
**dadurch gekennzeichnet, dass**
das Anschlusselement ausgewählt ist aus der Gruppe der Kühlelemente umfassend Kühlkörper und Kühlplatten.

16. Kondensator-Anschlusselement-Anordnung nach einem der vorherigen Ansprüche 12 bis 15,
**dadurch gekennzeichnet, dass**
die Haltereinrichtung (10) im unteren Teilbereich (21) und das Anschlusselement zusammenwirkende Verbindungsmittel aufweisen, um beim Verbinden von Anschlusselement, Folie (50) und Halter-Kondcnsatoranordnung einen ausreichenden Anpressdruck zu realisieren

17. Kondensator-Anschlusselement-Anordnung nach einem der vorherigen Ansprüche 12 bis 16,
**dadurch gekennzeichnet, dass**
der Becherboden vor Verbinden von Anschlusselement, Folie (50) und Halter-Kondensatoranordnung mit etwas Spiel über den Bodenbereich der Haltereinrichtung (10) hervorsteht, um einen ausreichend hohen Anpressdruck zwischen Kondensator und Anschlusselement zu realisieren.

## Claims

1. Holding device (10) suited for a capacitor, in particular for an aluminum electrolyte capacitor, for mounting the capacitor to a connection element, comprising:
a body (20) and
a continuous through opening (30) axially penetrating the body (20) for receiving the capacitor,
said through opening (30) having essentially the same internal dimensions as the outer dimensions of the capacitor to be received that, in assembled state, penetrates at least partially the body (20) or the through opening (30), to receive the capacitor,
**characterized in that**
the body (20) comprises multiple portions,
a lower portion (21) with joining means for joining the body (20) to a connection element by pressing said body (20) against the connection element, and with a lower through opening dimension allowing the capacitor to be received with backlash,
a middle portion (22) with a smaller middle through opening dimension relative to the lower through opening dimension, said middle portion (22) and the lower portion (21) thus forming a first inner shoulder between them, and
an upper portion (23) with a smaller upper through opening dimension relative to the middle through opening dimension, said upper portion (23) and the middle portion (22) thus forming a second inner shoulder between them.

2. Holding device (10) according to claim 1,
**characterized in that**
the body (20) or the portions (21, 22, 23) have an essentially annular shape.

3. Holding device (10) according to claim 1 or 2,
**characterized in that**
the cross-sections of the through opening (30) are designed as circular cross-sections.

4. Holding device (10) according to any one of the preceding claims 1 to 3,
**characterized in that**
the upper portion (23) has a thinned wall thickness to provide a resilient effect.

5. Holding device (10) according to any one of the preceding claims 1 to 4,
**characterized in that**
the upper portion (23) has recesses (40) formed along its periphery to form tongue-type resilient guiding means.

6. Holding device (10) according to any one of the preceding claims 1 to 5,
**characterized in that**
the body (20) is made of a sufficiently robust material selected from the group of the plastic materials comprising PBT (polybutylene terephthalate).

7. Holder-capacitor assembly comprising:
a capacitor with
a cup having a cup bottom and
a circumferential outer insulation,
selected from the group of the electrolyte capacitors comprising aluminum electrolyte capacitors and
a corresponding holder,
**characterized in that**
the holder comprises a holding apparatus comprising a retaining ring and a holding device (10) according to any one of the preceding claims.

8. Holder-capacitor assembly according to claim 7,
**characterized in that**
the cup bottom is designed without shoulders.

9. Holder-capacitor assembly according to one of claims 7 or 8, **characterized in that**
the outer insulation is essentially flush with the cup bottom.

10. Holder-capacitor assembly according to any one of the preceding claims 7 to 9.
**characterized in that**
the capacitor has an at least partially circumferential radial nose that interacts with the first inner shoulder to provide a stopper when joining the holder and the capacitor.

11. Holder-capacitor assembly according to any one of the preceding claims 7 to 10.
**characterized in that**
the capacitor has an at least partially circumferential radial recess that interacts with the second inner shoulder to realize centering when joining the holder and the capacitor.

12. Capacitor-connection element assembly, **characterized by**:
a holder-capacitor assembly according to any one of the preceding claims 7 to 11,
a connection element adapted to be connected to the holder, and a foil (50) sandwiched between the cup bottom and the connection element, said foil (50) being designed so as to ensure a sufficient creepage distance.

13. Capacitor-connection element assembly according to claim 12,
**characterized in that**
the foil (50) is designed so as to realize a suitable heat dissipation.

14. Capacitor-connection element assembly according to claim 12 or 13,
**characterized in that**
the foil (50) covers the entire contact surface between the cup bottom and the connection element and/or the holding device (10) and the connection element.

15. Capacitor-connection element assembly according to any one of the preceding claims 12 to 14,
**characterized in that**
the connection element is selected from the group of the cooling elements comprising heat sinks and cooling plates.

16. Capacitor-connection element assembly according to any one of the preceding claims 12 to 15,
**characterized in that**
the holding device (10) in the lower portion (21) and the connection element have interacting joining means to realize a sufficient contact pressure when joining the connection element, the foil (50) and the holder-capacitor assembly.

17. Capacitor-connection element assembly according to any one of the preceding claims 12 to 16,
**characterized in that**
the cup bottom protrudes with some backlash over the bottom area of the holding device (10) before joining the connection element, the foil (50) and the holder-capacitor assembly to realize a sufficiently high contact pressure between the capacitor and the connection element.

## Revendications

1. Dispositif de support (10) adapté pour un condensateur, en particulier pour un condensateur électrolytique en aluminium, pour fixer le condensateur à un élément de connexion, comprenant :
un corps (20) et
une ouverture de passage (30) continue traversant ledit corps (20) de manière axiale pour recevoir le condensateur,
ladite ouverture de passage (30) ayant des dimensions intérieures qui sont, pour l'essentiel, identiques aux dimensions extérieures du condensateur qu'elle doit recevoir et qui, en état monté, traverse au moins partiellement le corps (20) ou l'ouverture de passage (30), afin de recevoir le condensateur,
**caractérisé en ce que**
le corps (20) comprend plusieurs parties,
une partie inférieure (21) avec des moyens de liaison pour lier le corps (20) à un élément de connexion en pressant ledit corps (20) contre l'élément de connexion, et avec une dimension d'ouverture de passage inférieure qui permet de recevoir le condensateur avec jeu,
une partie moyenne (22) avec une dimension d'ouverture de passage moyenne plus petite relative à la dimension d'ouverture de passage inférieure, ladite partie moyenne (22) et ladite partie inférieure (21) formant ainsi un premier gradin intérieur entre elles, et
une partie supérieure (23) avec une dimension d'ouverture de passage supérieure plus petite relative à la dimension d'ouverture de passage moyenne, ladite partie supérieure (23) et ladite partie moyenne (22) formant ainsi un second gradin intérieur entre elles.

2. Dispositif de support (10) selon la revendication 1,
**caractérisé en ce que**
le corps (20) ou les parties (21, 22, 23) ont pour l'essentiel une forme annulaire,

3. Dispositif de support (10) selon la revendication 1 ou 2,
**caractérisé en ce que**
les coupes transversales de l'ouverture de passage (30) sont des coupes transversales circulaires.

4. Dispositif de support (10) selon l'une des revendications précédentes 1 à 3,
**caractérisé en ce que**
la partie supérieure (23) présente une épaisseur de mur réduite afin de réaliser un effet élastique.

5. Dispositif de support (10) selon l'une des revendications précédentes 1 à 4,
**caractérisé en ce que**
la partie supérieure (23) a des évidements (40) circonférentiels afin de former des moyens de guidage élastique du type de languettes.

6. Dispositif de support (10) selon l'une des revendications précédentes 1 à 5,
**caractérisé en ce que**
le corps (20) est fabriqué d'un matériau suffisamment stable sélectionné du groupe de matières plastiques comprenant PBT (polybutylène tériphtalate).

7. Ensemble support-condensateur, comprenant:
un condensateur avec
un boîtier avec un fond de boîtier, et
une isolation extérieure circonférentielle,
sélectionnée du groupe des condensateurs électrolytiques comprenant les condensateurs électrolytiques en aluminium et
un support correspondant,
**caractérisé en ce que**
ledit support comprend un appareil de support, comprenant un anneau de retenue et un dispositif de support (10) selon l'une des revendications précédentes.

8. Ensemble support-condensateur selon la revendication 7,
**caractérisé en ce que**
le fond de boîtier ne présente pas de gradins.

9. Ensemble support-condensateur selon l'une des revendications 7 ou 8,
**caractérisé en ce que**
l'isolation extérieure est pour l'essentiel à fleur du fond de boîtier

10. Ensemble support-condensateur selon l'une des revendications précédentes 7 à 9,
**caractérisé en ce que**
le condensateur présente, au moins en partie, une saillie circonférentielle radiale coopérant avec le premier gradin intérieur afin de réaliser une butée lors de la jonction du support et du condensateur.

11. Ensemble support-condensateur selon l'une des revendications 7 à 10,
**caractérisé en ce que**
le condensateur présente, au moins en partie, un évidement circonférentiel radial coopérant avec le second gradin intérieur afin de réaliser un centrage lors de la jonction du support et du condensateur.

12. Ensemble condensateur-élément de connexion, **caractérisé par**:
un ensemble support-condensateur selon l'une des revendications précédentes 7 à 11,
un élément de connexion adapté pour être lié au support, et
une feuille (50) intercalée entre le fond de boîtier et l'élément de connexion, ladite feuille (50) étant conçue pour assurer une ligne de fuite suffisante.

13. Ensemble condensateur-élément de connexion selon la revendication 12,
**caractérisé en ce que**
la feuille (50) est conçue pour réaliser une dissipation thermique appropriée.

14. Ensemble condensateur-élément de connexion selon la revendication 12 ou 13,
**caractérisé en ce que**
la feuille (50) couvre la surface de contact entière entre le fond de boîtier et l'élément de connexion et/ou le dispositif de support (10) et l'élément de connexion.

15. Ensemble condensateur-élément de connexion selon l'une des revendications précédentes 12 à 14,
**caractérisé en ce que**
l'élément de connexion est sélectionné du groupe des éléments de refroidissement comprenant des dissipateurs thermiques et des plaques de refroidissement.

16. Ensemble condensateur-élément de connexion selon l'une des revendications précédentes 12 à 15,
**caractérisé en ce que**
le dispositif de support (10) dans la partie inférieure (21) et l'élément de connexion présentent des moyens de liaison coopérant afin de réaliser une pression d'appui suffisante lors de la jonction de l'élément de connexion, de la feuille (50) et de l'ensemble support-condensateur.

17. Ensemble condensateur-élément de connexion selon l'une des revendications précédentes 12 à 16,
**caractérisé en ce que**
le fond de boîtier fait saillie avec un peu de jeu sur la région du fond du dispositif de support (10) avant de joindre l'élément de connexion, la feuille (50) et l'ensemble support-condensateur afin de réaliser une pression d'appui suffisante entre le condensateur et l'élément de connexion.
